# EUROPEAN PATENT APPLICATION

(11) **EP 3 467 876 A1**
(43) Date of publication of application: **10.04.2019**
(21) Application number: 18196700.1
(22) Date of filing: 25.09.2018
(51) Int. Cl.: H01L 29/739, H01L 29/78, H01L 29/20, H01L 29/08, H01L 21/336

(54) **NITRIDE SEMICONDUCTOR APPARATUS AND METHOD OF MANUFACTURING NITRIDE SEMICONDUCTOR APPARATUS**

(30) Priority: 06.10.2017 JP 2017196306
(71) Applicant: TOYOTA JIDOSHA KABUSHIKI KAISHA, Toyota-shi, Aichi-ken, 471-8571 (JP)
(72) Inventor: TOMITA, Hidemoto, TOYOTA-SHI, AICHI-KEN, 471-8571 (JP); UEDA, Hiroyuki, NAGAKUTE-SHI, AICHI-KEN, 480-1192 (JP); MORI, Tomohiko, NAGAKUTE-SHI, AICHI-KEN, 480-1192 (JP)
(74) Representative: Cabinet Beau de Loménie

(57) **Abstract**

A nitride semiconductor apparatus includes a nitride semiconductor layer (12), a gate insulating film (28), a source electrode (20), a drain electrode (30), and a gate electrode (26). The nitride semiconductor layer (12) includes a first body layer, a second body layer, a drift layer (44), a first source layer, and a second source layer. The drift layer (44) includes a first drift layer (46) that extends from a position in contact with a bottom surface of the first body layer to a position in contact with a bottom surface of the second body layer, and an electric field relaxation layer (48) that is in contact with a lower end portion of a side surface of the first body layer and a lower end portion of a side surface of the second body layer, is in contact with the first drift layer (46), and has a second conduction type impurity concentration lower than that of the first drift layer (46).

## Description

### BACKGROUND OF THE INVENTION

### 1. Field of the Invention

The present disclosure relates to a nitride semiconductor apparatus and a method of manufacturing a nitride semiconductor apparatus.

### 2. Description of Related Art

Katsunori Ueno (2017) "Development of Normally-Off MOSFET on Homoepitaxial GaN," Applied Physics, Vol. 86, No. 5, p. 376-380 discloses a semiconductor apparatus including a semiconductor layer, a gate insulating film, and a gate electrode. In the semiconductor apparatus, the semiconductor layer includes a first body layer, a second body layer, a drift layer, a first source layer, and a second source layer. The first body layer is of a first conduction type and is exposed to a front surface of the semiconductor layer. The second body layer is of a first conduction type and is exposed to the front surface of the semiconductor layer. An interval portion is provided between the first body layer and the second body layer. The drift layer is of a second conduction type, extends from the interval portion between the first body layer and the second body layer to a position in contact with a bottom surface of the first body layer and to a position in contact with a bottom surface of the second body layer, and is exposed to the front surface of the semiconductor layer in the interval portion. The first source layer is of a second conduction type, is separated from the drift layer by the first body layer, and is exposed to the front surface of the semiconductor layer. The second source layer is of a second conduction type, is separated from the drift layer by the second body layer, and is exposed to the front surface of the semiconductor layer. The gate insulating film covers the front surface of the semiconductor layer over a range in which the first source layer, the first body layer, the drift layer, the second body layer, and the second source layer are exposed. The gate electrode faces the first body layer and the second body layer through the gate insulating film.

When the vertical type semiconductor apparatus described above is turned on, a potential of the gate electrode increases to be equal to or higher than a gate threshold. As a result, a channel is formed near the gate insulating film of the first body layer and near the gate insulating film of the second body layer. Carriers flow between a source layer (that is, the first source layer and the second source layer) and the drift layer by way of the channel. With this, electric conduction is provided between a source electrode formed on the front surface of the semiconductor layer and a drain electrode formed on a rear surface of the semiconductor layer. In a case where the potential of the gate electrode decreases to be less than the gate threshold, the channel disappears, and the flow of the carriers is stopped. With this, the semiconductor apparatus is turned off.

### SUMMARY OF THE INVENTION

In Katsunori Ueno (2017) "Development of Normally-Off MOSFET on Homoepitaxial GaN," Applied Physics, Vol. 86, No. 5, p. 376-380, when the semiconductor apparatus is turned off, a reverse voltage is applied to pn junctions of interfaces between the body layers (that is, the first body layer and the second body layer) and the drift layer. For this reason, depletion layers spread from the body layers to the drift layer, and the drift layer is depleted. As a result, a potential distribution is generated inside the drift layer, and an electric field is applied to the drift layer. As a result of studying this, it is understood that, when the semiconductor apparatus is turned off, a high electric field concentrates surrounding a lower end portion of each body layer on the interval portion side, and a withstand voltage of the semiconductor apparatus decreases. The present disclosure provides a vertical type nitride semiconductor apparatus capable of relaxing an electric field surrounding a lower end portion of a body layer on an interval portion side and a method of manufacturing a nitride semiconductor apparatus.

A first aspect of the present disclosure relates to a nitride semiconductor apparatus. The nitride semiconductor apparatus includes a nitride semiconductor layer, a gate insulating film, a source electrode, a drain electrode, and a gate electrode. The nitride semiconductor layer includes a first body layer, a second body layer, a drift layer, a first source layer, and a second source layer. The first body layer is a first conduction type layer that is exposed to a front surface of the nitride semiconductor layer. The second body layer is a first conduction type layer that is exposed to the front surface. The drift layer is a second conduction type layer that extends from an interval portion to a position in contact with a bottom surface of the first body layer and a position in contact with a bottom surface of the second body layer, and is exposed to the front surface in the interval portion, the interval portion being a region between the first body layer and the second body layer. The first source layer is a second conduction type layer that is separated from the drift layer by the first body layer and is exposed to the front surface. The second source layer is a second conduction type layer that is separated from the drift layer by the second body layer and is exposed to the front surface. The gate insulating film covers the front surface over a range in which the first source layer, the first body layer, the drift layer, the second body layer, and the second source layer are exposed. The source electrode is in contact with the first source layer, the first body layer, the second source layer, and the second body layer within a range in which the gate insulating film is not provided. The drain electrode is in contact with a rear surface of the nitride semiconductor layer. The gate electrode faces the first body layer and the second body layer through the gate insulating film. The drift layer includes a first drift layer that extends from the position in contact with the bottom surface of the first body layer to the position in contact with the bottom surface of the second body layer, and an electric field relaxation layer that is in contact with a first lower end portion and a second lower end portion, is in contact with the first drift layer, and has a second conduction type impurity concentration lower than that of the first drift layer. The first lower end portion is a lower end portion of a side surface of the first body layer on the interval portion side, and the second lower end portion is a lower end portion of a side surface of the second body layer on the interval portion side.

When the nitride semiconductor apparatus is turned off, the electric field relaxation layer and the first drift layer are depleted. The second conduction type impurity concentration of the electric field relaxation layer is lower than the second conduction type impurity concentration of the first drift layer. For this reason, a concentration of a fixed electric charge (second conduction type impurity) in the depleted electric field relaxation layer is lower than a concentration of a fixed electric charge (second conduction type impurity) in the depleted first drift layer. Accordingly, inside the depleted electric field relaxation layer, an electric field is more hardly generated than inside the depleted first drift layer. In the nitride semiconductor layer, since the electric field relaxation layer is disposed at the position in contact with the lower end portion of the side surface of each body layer on the interval portion side, it is possible to relax an electric field surrounding the lower end portion of each body layer on the interval portion side. With this, it is possible to improve a withstand voltage of the nitride semiconductor apparatus.

In the nitride semiconductor apparatus according to the first aspect of the present disclosure, the electric field relaxation layer may extend from the first lower end portion to the second lower end portion. The drift layer may include a second drift layer that is disposed in the interval portion on the front surface side from the electric field relaxation layer and has a second conduction type impurity concentration higher than that of the electric field relaxation layer.

According to the first aspect of the present disclosure, since the second conduction type impurity concentration of the second drift layer provided in the interval portion is higher than the second conduction type impurity concentration of the electric field relaxation layer, it is possible to reduce resistance to a current flowing in the interval portion.

In the nitride semiconductor apparatus according to the first aspect of the present disclosure, the electric field relaxation layer may include a first portion that is in contact with the first lower end portion, and a second portion that is in contact with the second lower end portion and is separated from the first portion. The drift layer may include a second drift layer that is disposed in the interval portion, has a second conduction type impurity concentration higher than that of the electric field relaxation layer, and is connected to the first drift layer between the first portion and the second portion.

In the first aspect of the present disclosure, the second drift layer provided in the interval portion is connected to the first drift layer between the first portion and the second portion. Since the second conduction type impurity concentration of the second drift layer is higher than the second conduction type impurity concentration of the electric field relaxation layer, a current flows in a connection portion of the first drift layer and the second drift layer, whereby it is possible to further reduce resistance to the current.

In the nitride semiconductor apparatus according to the first aspect of the present disclosure, the electric field relaxation layer may extend to the front surface in the interval portion.

In the nitride semiconductor apparatus according to the first aspect of the present disclosure, the drift layer may include a drain contact layer that is disposed on the rear surface side from the first drift layer, is exposed to the rear surface, and has a second conduction type impurity concentration higher than that of the first drift layer.

A second aspect of the present disclosure relates to a method of manufacturing a nitride semiconductor apparatus. The method includes making a first drift layer grow, making a body layer grow, forming a recess portion, making an electric field relaxation layer grow, grinding the electric field relaxation layer, forming a source layer, forming a gate insulating film, forming a gate electrode, forming a source electrode, and forming a drain electrode. In making the first drift layer grow, the first drift layer made of a second conduction type nitride semiconductor is made to grow on a front surface of a nitride semiconductor substrate made of a second conduction type nitride semiconductor. In making the body layer grow, the body layer made of a first conduction type nitride semiconductor is made to grow on a front surface of the first drift layer. In the forming of the recess portion, the recess portion that passes through the body layer from a front surface of the body layer and reaches the first drift layer is formed. In making the electric field relaxation layer grow, the electric field relaxation layer made of a second conduction type nitride semiconductor having a second conduction type impurity concentration lower than that of the first drift layer is made to grow inside the recess portion and on the front surface of the body layer. In the grinding of the electric field relaxation layer, the electric field relaxation layer is grinded to expose the front surface of the body layer and to make the electric field relaxation layer remain inside the recess portion. In the forming of the source layer, the second conduction type source layer that is separated from the first drift layer and the electric field relaxation layer by the body layer and is exposed to the front surface of the body layer is formed on both sides of the recess portion. In the forming of the gate insulating film, the gate insulating film that covers a range over a front surface of each source layer, the front surface of the body layer, and a front surface of the electric field relaxation layer is formed. In the forming of the gate electrode, the gate electrode that faces the body layer through the gate insulating film is formed. In the forming of the source electrode, the source electrode is formed on the front surface of each source layer and the front surface of the body layer within a range in which the gate insulating film is not provided. In the forming of the drain electrode, the drain electrode is formed on a rear surface of the nitride semiconductor substrate.

In the above-described manufacturing method, the recess portion that passes through the body layer and reaches the first drift layer is formed, and the electric field relaxation layer is made to grow inside the recess portion. For this reason, it is possible to dispose the electric field relaxation layer at the position in contact with the lower end portion of the body layer. Accordingly, with the above-described manufacturing method, it is possible to suppress concentration of an electric field surrounding the lower end portion of the body layer on the recess portion side when the semiconductor apparatus is turned off.

A third aspect of the present disclosure relates to a method of manufacturing a nitride semiconductor apparatus. The method includes making a first drift layer grow, making a body layer grow, forming a recess portion, making an electric field relaxation layer grow, and etching the electric field relaxation layer, making a second drift layer grow, forming a source layer, forming a gate insulating film, forming a gate electrode, forming a source electrode, and forming a drain electrode. In making the first drift layer grow, the first drift layer made of a second conduction type nitride semiconductor is made to grow on a front surface of a nitride semiconductor substrate made of a second conduction type nitride semiconductor. In making the body layer grow, the body layer made of a first conduction type nitride semiconductor is made to grow on a front surface of the first drift layer. In the forming of the recess portion, the recess portion that passes through the body layer from a front surface of the body layer and reaches the first drift layer is formed. In making the electric field relaxation layer grow, the electric field relaxation layer made of a second conduction type nitride semiconductor having a second conduction type impurity concentration lower than that of the first drift layer is made to grow inside the recess portion and on the front surface of the body layer. In the etching of the electric field relaxation layer, the electric field relaxation layer on the body layer is removed to expose the front surface of the body layer and to make the electric field relaxation layer remain at a position in contact with at least a lower end portion of each side surface of the body layer on the recess portion side. In making the second drift layer grow, after the electric field relaxation layer is etched, the second drift layer made of a second conduction type nitride semiconductor having a second conduction type impurity concentration higher than that of the electric field relaxation layer is made to grow inside the recess portion. In the forming of the source layer, the second conduction type source layer that is separated from the first drift layer, the electric field relaxation layer, and the second drift layer by the body layer and is exposed to the front surface of the body layer is formed on both sides of the recess portion. In the forming of the gate insulating film, the gate insulating film that covers a range over a front surface of each source layer, the front surface of the body layer, and a front surface of the second drift layer is formed. In the forming of the gate electrode, the gate electrode that faces the body layer through the gate insulating film is formed. In the forming of the source electrode, the source electrode is formed on the front surface of each source layer and the front surface of the body layer within a range in which the gate insulating film is not provided. In the forming of the drain electrode, the drain electrode is formed on a rear surface of the nitride semiconductor substrate.

In the above-described manufacturing method, the recess portion that passes through the body layer and reaches the first drift layer is formed, and the electric field relaxation layer is made to grow in the recess portion. For this reason, it is possible to dispose the electric field relaxation layer at the position in contact with the lower end portion of the body layer. Accordingly, in a semiconductor apparatus manufactured by the above-described manufacturing method, it is possible to suppress concentration of an electric field on the lower end portion of the body layer on the recess portion side when the semiconductor apparatus is turned off. In the above-described manufacturing method, after the electric field relaxation layer is formed, the second drift layer is formed inside the recess portion. For this reason, it is possible to use the first drift layer and the second drift layer as a current path when the semiconductor apparatus is turned on. The second conduction type impurity concentrations of the first drift layer and the second drift layer are higher than the second conduction type impurity concentration of the electric field relaxation layer. For this reason, with a semiconductor apparatus manufactured by the above-described manufacturing method, it is possible to reduce on-resistance.

### BRIEF DESCRIPTION OF THE DRAWINGS

Features, advantages, and technical and industrial significance of exemplary embodiments of the invention will be described below with reference to the accompanying drawings, in which like numerals denote like elements, and wherein:
FIG. 1 is a longitudinal sectional view of a MOSFET of Example 1;
FIG. 2 is an explanatory view of a manufacturing process of the MOSFET of Example 1;
FIG. 3 is an explanatory view of the manufacturing process of the MOSFET of Example 1;
FIG. 4 is an explanatory view of the manufacturing process of the MOSFET of Example 1;
FIG. 5 is an explanatory view of the manufacturing process of the MOSFET of Example 1;
FIG. 6 is an explanatory view of the manufacturing process of the MOSFET of Example 1;
FIG. 7 is an explanatory view of the manufacturing process of the MOSFET of Example 1;
FIG. 8 is a longitudinal sectional view of a MOSFET of Example 2;
FIG. 9 is an explanatory view of a manufacturing process of the MOSFET of Example 2;
FIG. 10 is an explanatory view of the manufacturing process of the MOSFET of Example 2;
FIG. 11 is an explanatory view of the manufacturing process of the MOSFET of Example 2;
FIG. 12 is an explanatory view of the manufacturing process of the MOSFET of Example 2;
FIG. 13 is an explanatory view of the manufacturing process of the MOSFET of Example 2;
FIG. 14 is a longitudinal sectional view of a MOSFET of Example 3; and
FIG. 15 is an explanatory view of a manufacturing process of the MOSFET of Example 3.

### DETAILED DESCRIPTION OF EMBODIMENTS

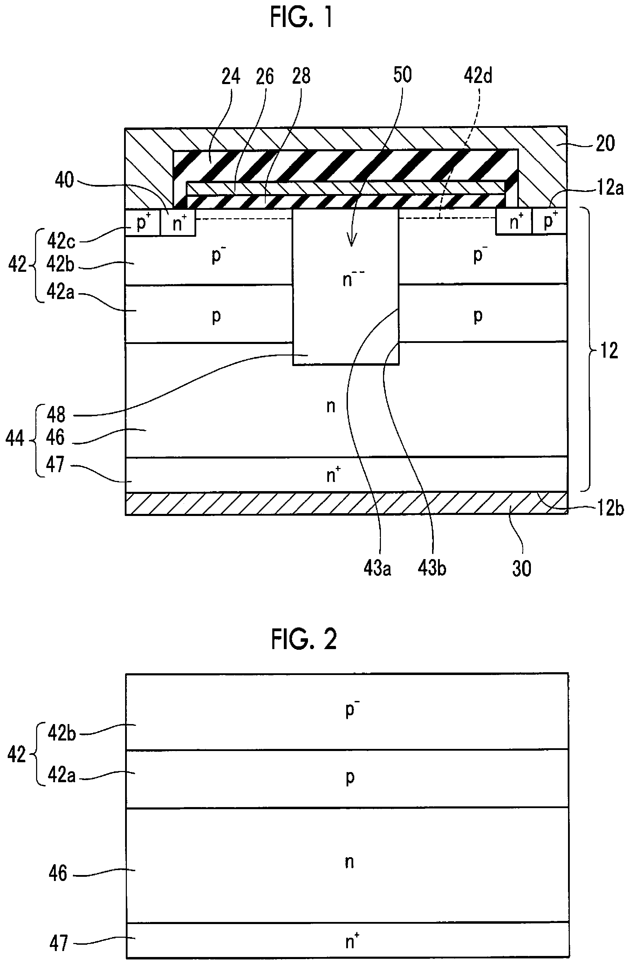

A metal-oxide-semiconductor field-effect transistor (MOSFET) shown in FIG. 1 has a nitride semiconductor layer 12. The nitride semiconductor layer 12 is a semiconductor layer made primarily of gallium nitride (GaN).

The nitride semiconductor layer 12 has a plurality of source layers 40, a plurality of body layers 42, and a drift layer 44.

Each source layer 40 is an n-type region and is exposed to a front surface 12a of the nitride semiconductor layer 12.

Each body layer 42 is a p-type region and is disposed in the vicinity of the corresponding source layer 40. Each body layer 42 covers a side surface and a lower surface of the corresponding source layer 40. Each body layer 42 is exposed to the front surface 12a of the nitride semiconductor layer 12 within a range adjacent to the source layer 40. The body layers 42 are disposed at intervals. Hereinafter, an interval portion between the body layers 42 is referred to as an interval portion 50. The interval portion 50 may be referred to as a junction field-effect transistor (JFET) region. Each body layer 42 has a high concentration region 42a, a low concentration region 42b, and a body contact region 42c.

The low concentration region 42b is exposed to the front surface 12a of the nitride semiconductor layer 12 within a range between the interval portion 50 and the source layer 40. The low concentration region 42b is in contact with a side surface on the interval portion 50 side and a bottom surface of the source layer 40. The high concentration region 42a is disposed below the low concentration region 42b. A p-type impurity concentration of the high concentration region 42a is higher than a p-type impurity concentration of the low concentration region 42b. The body contact region 42c is exposed to the front surface 12a of the nitride semiconductor layer 12 within a range on an opposite side of the source layer 40 from the interval portion 50. A lower surface of the body contact region 42c is covered with the low concentration region 42b. A p-type impurity concentration of the body contact region 42c is higher than a p-type impurity concentration of the high concentration region 42a.

The drift layer 44 is an n-type region and extends from the interval portion 50 to a position in contact with a bottom surface of each body layer 42. Inside the interval portion 50, the drift layer 44 is exposed to the front surface 12a of the nitride semiconductor layer 12. The drift layer 44 is exposed to the substantially entire region of a rear surface 12b of the nitride semiconductor layer 12. The drift layer 44 is separated from each source layer 40 by each body layer 42. The drift layer 44 has a first drift layer 46, a drain contact layer 47, and an electric field relaxation layer 48.

The first drift layer 46 is disposed below each body layer 42. Regarding a pair of body layers 42, the first drift layer 46 extends from a position in contact with a bottom surface (a bottom surface of the high concentration region 42a) of the first body layer 42 to a position in contact with a bottom surface (a bottom surface of the high concentration region 42a) of the second body layer 42. The first drift layer 46 is separated from each source layer 40 by each body layer 42.

The drain contact layer 47 is disposed below the first drift layer 46. The drain contact layer 47 is exposed to the substantially entire region of the rear surface 12b of the nitride semiconductor layer 12. An n-type impurity concentration of the drain contact layer 47 is higher than an n-type impurity concentration of the first drift layer 46.

The electric field relaxation layer 48 is disposed over the entire region of the interval portion 50. Accordingly, the electric field relaxation layer 48 is in contact with a lower end portion 43b of a side surface 43a of each body layer 42 on the interval portion 50 side. The electric field relaxation layer 48 extends to a region below the interval portion 50. That is, the electric field relaxation layer 48 extends from a position exposed to the front surface 12a of the nitride semiconductor layer 12 below the lower end portion 43b of the side surface 43a of each body layer 42 on the interval portion 50 side. The electric field relaxation layer 48 is disposed above the first drift layer 46 and is in contact with the first drift layer 46. The electric field relaxation layer 48 is separated from each source layer 40 by each body layer 42. An n-type impurity concentration of the electric field relaxation layer 48 is lower than the n-type impurity concentration of the first drift layer 46.

A gate insulating film 28, a gate electrode 26, an insulating interlayer 24, and a source electrode 20 are disposed on the front surface 12a of the nitride semiconductor layer 12.

The gate insulating film 28 covers a part of the front surface 12a of the nitride semiconductor layer 12. The gate insulating film 28 covers the front surface 12a of the nitride semiconductor layer 12 over a range in which the source layers 40, the body layers 42 between the source layers 40 and the interval portion 50 (that is, the electric field relaxation layer 48), and the electric field relaxation layer 48 are exposed. In each body layer 42, a portion (that is, a surface layer portion of the body layer 42 between the source layer 40 and the electric field relaxation layer 48) in contact with the gate insulating film 28 is a channel region 42d where a channel is formed. The gate insulating film 28 is made of, for example, an insulator, such as silicon oxide.

The gate electrode 26 is disposed on the gate insulating film 28. The gate electrode 26 covers the entire region of a front surface of the gate insulating film 28. The gate electrode 26 faces a part of the source layers 40, the body layers 42 (that is, the channel regions 42d), and the electric field relaxation layer 48 through the gate insulating film 28. The gate electrode 26 is insulated from the nitride semiconductor layer 12 by the gate insulating film 28.

The insulating interlayer 24 covers a part of the source layers 40 within a range adjacent to the gate insulating film 28, a front surface of the gate electrode 26, and side surfaces of the gate insulating film 28. That is, the vicinity of the gate electrode 26 is covered with the gate insulating film 28 and the insulating interlayer 24. The insulating interlayer 24 is made of, for example, an insulator, such as silicon oxide.

The source electrode 20 covers the front surface 12a of the nitride semiconductor layer 12 within a range adjacent to the insulating interlayer 24, and a front surface of the insulating interlayer 24. The source electrode 20 is insulated from the gate electrode 26 by the insulating interlayer 24. The source electrode 20 is connected to the source layers 40 and the body contact regions 42c.

The drain electrode 30 is disposed on the rear surface 12b of the nitride semiconductor layer 12. The drain electrode 30 is connected to the drift layer 44 (drain contact layer 47).

In a case where a potential of the gate electrode 26 increases to be equal to or higher than a gate threshold (a minimum gate potential needed for turning on the MOSFET), electrons are attracted to the channel region 42d of each body layer 42, whereby a channel is formed in the channel region 42d. With the channel, each source layer 40 and the drift layer 44 (electric field relaxation layer 48) are connected, and electrons flow from the source layer 40 to the electric field relaxation layer 48. The electrons flowing into the electric field relaxation layer 48 pass through the first drift layer 46 and the drain contact layer 47 and flow toward the drain electrode 30. With this, electric conduction is provided between the source electrode 20 and the drain electrode 30, and the MOSFET is turned on.

In a case where the potential of the gate electrode 26 decreases to be less than the gate threshold, the channel disappears, and the flow of the electrons is stopped. That is, the MOSFET is turned off. In a case where the MOSFET is turned off, a reverse voltage (that is, a voltage such that the drift layer 44 has a potential higher than the body layer 42) is applied to a pn junction of an interface between each body layer 42 and the drift layer 44. A depletion layer spreads from the pn junction to the vicinity of the pn junction. Since a p-type impurity concentration of each body layer 42 is much higher than the n-type impurity concentrations of the first drift layer 46 and the electric field relaxation layer 48, the body layer 42 is hardly ever depleted excluding near the pn junction. Accordingly, the depletion layer primarily spreads from the pn junction to the first drift layer 46 and the electric field relaxation layer 48. For this reason, the substantially whole of the electric field relaxation layer 48 and the first drift layer 46 is depleted. In a case where the electric field relaxation layer 48 and the first drift layer 46 are depleted, a potential distribution is generated inside the electric field relaxation layer 48 and the first drift layer 46. Accordingly, an electric field is applied to the electric field relaxation layer 48 and the first drift layer 46.

The lower end portion 43b of the side surface 43a of the undepleted body layer 42 is in contact with the depleted electric field relaxation layer 48 and first drift layer 46 at an angle. For this reason, a shape of the body layer 42 becomes a shape in which a high electric field is easily generated near the lower end portion 43b.

In the MOSFET of Example 1, the electric field relaxation layer 48 is provided at the position in contact with the lower end portion 43b of the side surface 43a of the body layer 42 on the interval portion 50 side. The n-type impurity concentration of the electric field relaxation layer 48 is lower than the n-type impurity concentration of the first drift layer 46. For this reason, the density of a fixed electric charge (n-type impurity) inside the depleted electric field relaxation layer 48 is lower than the density of a fixed electric charge (n-type impurity) inside the depleted first drift layer 46. Accordingly, the electric field relaxation layer 48 has a characteristic that an electric field is hardly generated inside the electric field relaxation layer 48. Since the electric field relaxation layer 48 is provided at the position in contact with the lower end portion 43b of the side surface 43a of the body layer 42 on which an electric field easily concentrates in shape, an electric field near the lower end portion 43b can be relaxed by the electric field relaxation layer 48.

Since concentration of an electric field on the lower end portion 43b is suppressed by the electric field relaxation layer 48, it is possible to increase the n-type impurity concentration of the first drift layer 46 compared to during normal. For this reason, when the MOSFET is turned on, it is possible to reduce resistance (that is, on-resistance) of the first drift layer 46 compared to during normal.

In the above-described example, the body layer 42 has the high concentration region 42a having a relatively high p-type impurity concentration (hereinafter, referred to as a "high concentration region 42a"), the low concentration region 42b having a relatively low p-type impurity concentration (hereinafter, referred to as a "low concentration region 42b"), and the body contact region 42c. However, the p-type impurity concentration of the high concentration region 42a and the p-type impurity concentration of the low concentration region 42b may be substantially equal to each other. That is, the high concentration region 42a and the low concentration region 42b may be collectively regarded as one region. A p-type impurity concentration of an underlying layer (that is, reference numeral 42a) may be lower than a p-type impurity concentration of an overlying layer (that is, reference numeral 42b). The same applies to other examples described below.

A manufacturing method of the MOSFET of Example 1 will be described. As shown in FIG. 2, the first drift layer 46 as an n-type nitride semiconductor layer is made epitaxially grow on the drain contact layer 47 as an n-type nitride semiconductor substrate. The drain contact layer 47 is a substrate (GaN substrate) made primarily of gallium nitride (GaN). The n-type impurity concentration of the first drift layer 46 is lower than an n-type impurity concentration of the drain contact layer 47. The body layer 42 as a p-type nitride semiconductor layer is made epitaxially grow on the first drift layer 46. In detail, after the high concentration region 42a is made epitaxially grow on the first drift layer 46, the low concentration region 42b as a p-type nitride semiconductor layer is made epitaxially grow on the high concentration region 42a. The p-type impurity concentration of the low concentration region 42b is lower than the p-type impurity concentration of the high concentration region 42a. A buffer layer as an n-type nitride semiconductor layer may be interposed between the drain contact layer 47 and the first drift layer 46. That is, after the buffer layer is made to grow on the drain contact layer 47, the first drift layer 46 may be made to grow on the buffer layer.

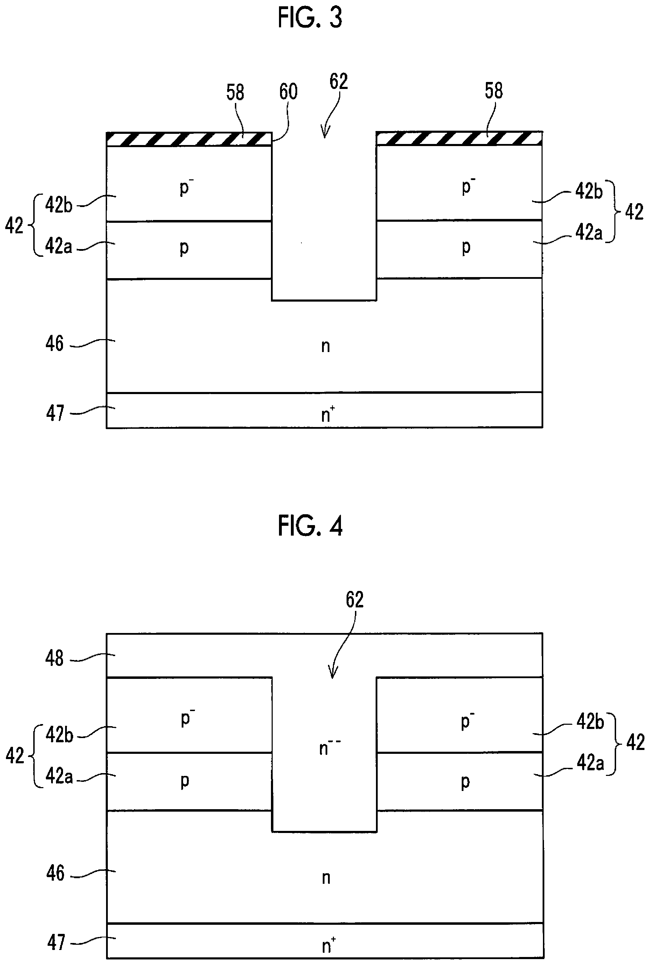

As shown in FIG. 3, a mask 58 having an opening 60 is formed on a front surface of the body layer 42 (low concentration region 42b). The front surface of the body layer 42 inside the opening 60 is etched, whereby a recess portion 62 is formed. The recess portion 62 is formed to pass through the body layer 42 and to reach the first drift layer 46. The mask 58 is removed, and as shown in FIG. 4, the electric field relaxation layer 48 as an n-type nitride semiconductor layer is made epitaxially grow on the front surface of each body layer 42 (low concentration region 42b) and inside the recess portion 62. In this case, the electric field relaxation layer 48 is made to grow such that the recess portion 62 is filled therewith. The n-type impurity concentration of the electric field relaxation layer 48 is lower than the n-type impurity concentration of the first drift layer 46.

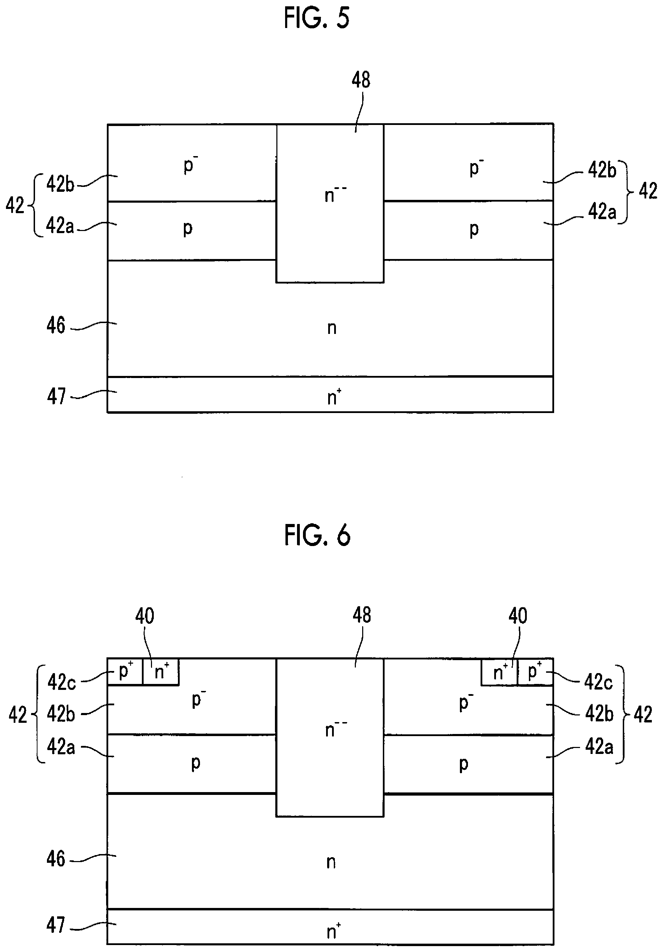

As shown in FIG. 5, a front surface of the electric field relaxation layer 48 is polished by chemical mechanical polishing (CMP). Here, as shown in FIG. 5, the front surface of each body layer 42 (low concentration region 42b) is exposed, and the front surface of each body layer 42 and the front surface of the electric field relaxation layer 48 are planarized.

As shown in FIG. 6, n-type impurity ions are selectively implanted into a part of each body layer 42 (low concentration region 42b), whereby each source layer 40 is formed. Each source layer 40 is separated from the first drift layer 46 and the electric field relaxation layer 48 by each body layer 42, and is formed to be exposed to the front surface of each body layer 42. As shown in FIG. 6, p-type impurity ions are implanted into a part of each body layer 42 (low concentration region 42b), whereby the body contact region 42c is formed.

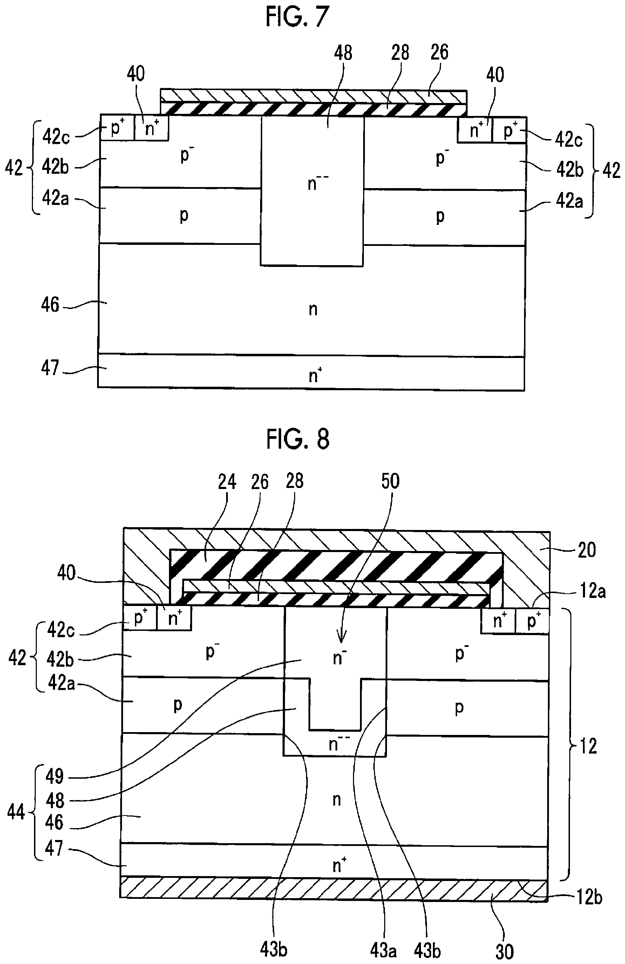

As shown in FIG. 7, the gate insulating film 28 is formed. The gate insulating film 28 is formed to cover a range over the front surface of each source layer 40, the front surface of each body layer 42, and the front surface of the electric field relaxation layer 48. As shown in FIG. 7, the gate electrode 26 is formed to cover the entire front surface of the gate insulating film 28. Thereafter, the insulating interlayer 24, the source electrode 20, and the drain electrode 30 are formed, whereby the MOSFET of FIG. 1 is completed. As shown in FIG. 1, the source electrode 20 is formed to be in contact with the front surface of each source layer 40 and the front surface of each body layer 42 within a range in which the gate insulating film 28 is not provided. The drain electrode 30 is formed to be in contact with a rear surface of the drain contact layer 47 (GaN substrate).

As described above, with the above-described manufacturing method, the recess portion 62 that passes through the body layer 42 and reaches the first drift layer 46 is formed, and the electric field relaxation layer 48 is made to grow in the recess portion 62. For this reason, it is possible to dispose the electric field relaxation layer 48 at the position in contact with the lower end portion 43b of each body layer 42. Accordingly, with the above-described manufacturing method, it is possible to suppress concentration of an electric field on the lower end portion 43b of each body layer 42 on the recess portion 62 side when the MOSFET is turned off.

Each source layer 40 and each body contact region 42c may not be formed at the above-described timing. That is, each source layer 40 and each body contact region 42c may be formed at any timing after the high concentration region 42a and the low concentration region 42b are made to grow (see FIG. 2). The same applies to a manufacturing method of a MOSFET of other examples.

Referring to FIG. 8, a MOSFET of Example 2 will be described. In the configuration of the MOSFET of Example 2, description of the configurations common to the MOSFET of Example 1 will not be repeated. In the MOSFET of Example 2, as shown in FIG. 8, the drift layer 44 further has a second drift layer 49. The second drift layer 49 and the electric field relaxation layer 48 are disposed inside the interval portion 50.

The electric field relaxation layer 48 extends from a position in contact with near an upper end of the high concentration region 42a of each body layer 42 to a position below the lower end portion 43b along the high concentration region 42a. The electric field relaxation layer 48 extends from the lower end portion 43b of the first body layer 42 to the lower end portion 43b of the second body layer 42.

The second drift layer 49 is disposed in the interval portion 50 on the front surface 12a side from the electric field relaxation layer 48. The second drift layer 49 is exposed to the front surface 12a of the nitride semiconductor layer 12 inside the interval portion 50. An n-type impurity concentration of the second drift layer 49 is higher than the n-type impurity concentration of the electric field relaxation layer 48. The n-type impurity concentration of the first drift layer 46 and the n-type impurity concentration of the second drift layer 49 are not limited. That is, the n-type impurity concentration of the first drift layer 46 may be higher than the n-type impurity concentration of the second drift layer 49, or the n-type impurity concentration of the first drift layer 46 may be lower than the n-type impurity concentration of the second drift layer 49. The n-type impurity concentration of the first drift layer 46 and the n-type impurity concentration of the second drift layer 49 may be equal to each other. The n-type impurity concentration of the first drift layer 46 and the n-type impurity concentration of the second drift layer 49 may be higher than the n-type impurity concentration of the electric field relaxation layer 48.

Even in the MOSFET of Example 2, since the electric field relaxation layer 48 is provided at the position in contact with the lower end portion 43b of the side surface 43a of the body layer 42 on the interval portion 50 side, an electric field hardly concentrates on the lower end portion 43b. In the MOSFET, since the second drift layer 49 having an n-type impurity concentration higher than the n-type impurity concentration of the electric field relaxation layer 48 is provided on the front surface 12a from the electric field relaxation layer 48, it is possible to reduce resistance of the JFET region when the MOSFET is turned on compared to the MOSFET of Example 1.

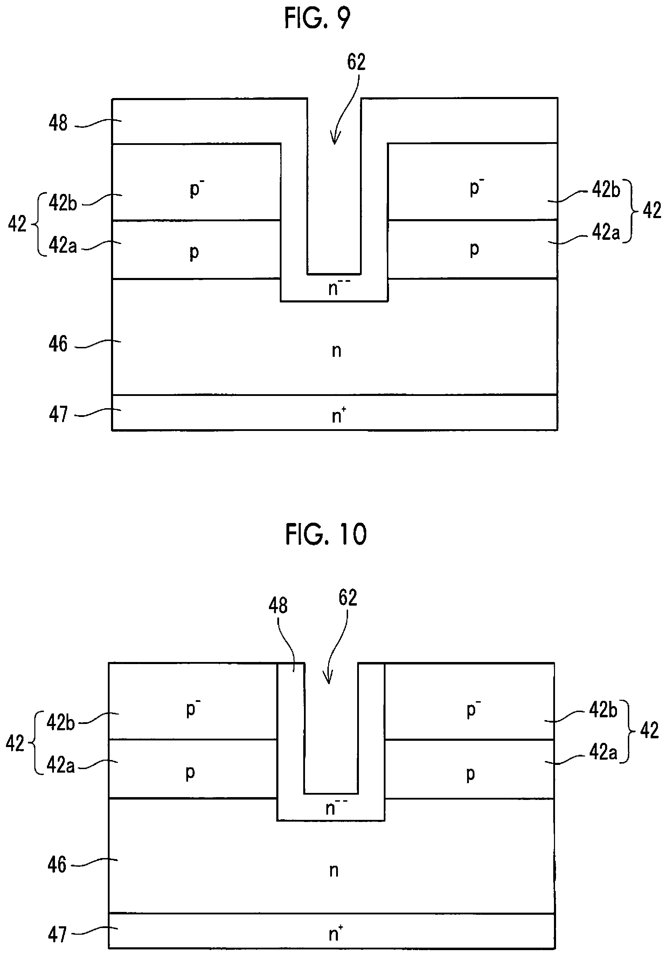

A manufacturing method of the MOSFET of Example 2 will be described. In the MOSFET of Example 2, after the recess portion 62 shown in FIG. 3 is formed, the mask 58 is removed, and as shown in FIG. 9, the electric field relaxation layer 48 as an n-type nitride semiconductor layer is made epitaxially grow on the front surface of each body layer 42 (low concentration region 42b) and inside the recess portion 62. In this case, the electric field relaxation layer 48 is made to grow such that the recess portion 62 is not completely filled therewith.

As shown in FIG. 10, the front surface of the electric field relaxation layer 48 is polished by CMP. Here, as shown in FIG. 10, the front surface of each body layer 42 (low concentration region 42b) is exposed, and the front surface of each body layer 42 and the front surface of the electric field relaxation layer 48 are planarized.

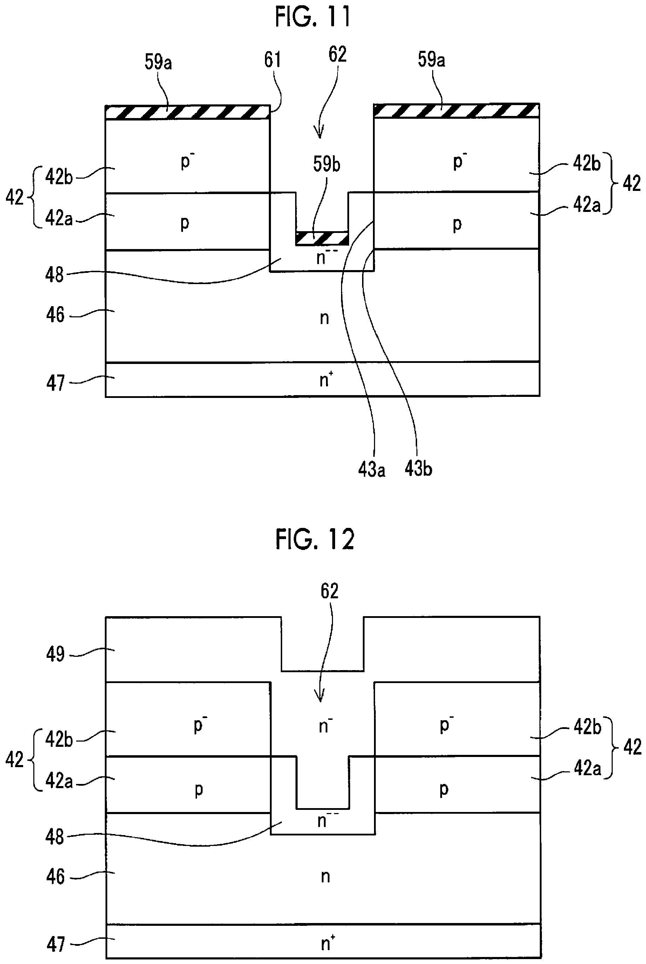

A mask 59a is formed on the front surface of each body layer 42, and a mask 59b is formed on a bottom surface of the electric field relaxation layer 48. The mask 59a has an opening 61 above the recess portion 62. The front surface of the electric field relaxation layer 48 is etched inside the opening 61, whereby, as shown in FIG. 11, an electric field relaxation layer 48 is removed surrounding the opening of the recess portion 62. Since the mask 59 b is formed on the bottom surface of the electric field relaxation layer 48, the electric field relaxation layer 48 remains in a bottom portion of the recess portion 62. The electric field relaxation layer 48 remains to extend from the lower end portion 43b of the side surface 43a of the first body layer 42 to the lower end portion 43b of the side surface 43a of the second body layer 42.

The mask 59a and the mask 59b are removed, and as shown in FIG. 12, the second drift layer 49 as an n-type nitride semiconductor layer is made epitaxially grow on the front surface of each body layer 42 (low concentration region 42b) and inside the recess portion 62. In this case, the second drift layer 49 is made to grow such that the recess portion 62 is filled therewith. The n-type impurity concentration of the second drift layer 49 is higher than the n-type impurity concentration of the electric field relaxation layer 48.

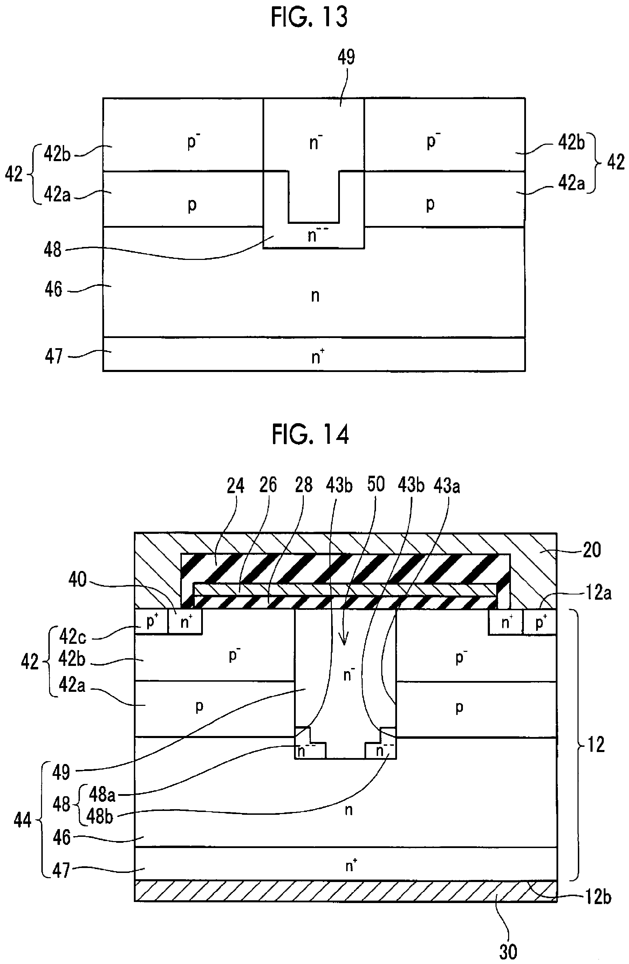

As shown in FIG. 13, the front surface of the second drift layer 49 is polished by CMP. Here, as shown in FIG. 13, the front surface of each body layer 42 (low concentration region 42b) is exposed. The second drift layer 49 is made remains inside the recess portion 62.

Thereafter, as in Example 1, each source layer 40 and each body contact region 42c are formed. Each source layer 40 is formed to be separated from the first drift layer 46, the electric field relaxation layer 48, and the second drift layer 49 by each body layer 42 and to be exposed to the front surface of each body layer 42. As in Example 1, the gate insulating film 28 and the gate electrode 26 are formed. The gate insulating film 28 is formed to cover a range over the front surface of each source layer 40, the front surface of each body layer 42, and the front surface of the second drift layer 49. Thereafter, the insulating interlayer 24, the source electrode 20, and the drain electrode 30 are formed, whereby the MOSFET of FIG. 8 is completed.

As described above, with the above-described manufacturing method, the recess portion 62 that passes through the body layer 42 and reaches the first drift layer 46 is formed, and the electric field relaxation layer 48 is made to grow in the recess portion 62. For this reason, it is possible to dispose the electric field relaxation layer 48 at the position in contact with the lower end portion 43b of each body layer 42. Accordingly, with the above-described manufacturing method, it is possible to suppress concentration of an electric field on the lower end portion 43b of each body layer 42 on the recess portion 62 side when the MOSFET is turned off. In the above-described manufacturing method, after the electric field relaxation layer 48 is formed, the second drift layer 49 is formed inside the recess portion 62. For this reason, it is possible to use the first drift layer 46 and the second drift layer 49 as a current path when the MOSFET is turned on. The second conduction type impurity concentrations of the first drift layer 46 and the second drift layer 49 are higher than the second conduction type impurity concentration of the electric field relaxation layer 48. For this reason, with the MOSFET manufactured by the above-described manufacturing method, it is possible to reduce on-resistance.

A MOSFET of Example 3 will be described referring to FIG. 14. The MOSFET of Example 3 is different in the configuration of an electric field relaxation layer 48 from the MOSFET of Example 2. As shown in FIG. 14, the electric field relaxation layer 48 has a first portion 48a that is in contact with the lower end portion 43b of the first body layer 42, and a second portion 48b that is in contact with the lower end portion 43b of the second body layer 42 and is separated from the first portion 48a.

The first portion 48a is disposed in an L shape at a position in contact with the lower end portion 43b of the first body layer 42. The first portion 48a extends below the lower end portion 43b of the first body layer 42. The second portion 48b is disposed in an L shape at a position in contact with the lower end portion 43b of the second body layer 42. The second portion 48b extends below the lower end portion 43b of the second body layer 42. The first drift layer 46 and the second drift layer 49 are connected within a range between the first portion 48a and the second portion 48b.

Even in the MOSFET of Example 3, since the electric field relaxation layer 48 (first portion 48a and second portion 48b) is provided at the positions in contact with the lower end portion 43b of the side surface 43 a of each body layer 42 on the interval portion 50 side, an electric field hardly concentrates on the lower end portion 43b. In the MOSFET, the first drift layer 46 and the second drift layer 49 are connected between the first portion 48a and the second portion 48b. Since the first drift layer 46 and the second drift layer 49 have an n-type impurity concentration higher than that of the electric field relaxation layer 48, when the MOSFET is turned on, a current flows in a connection portion of the first drift layer 46 and the second drift layer 49, whereby it is possible to further reduce on-resistance.

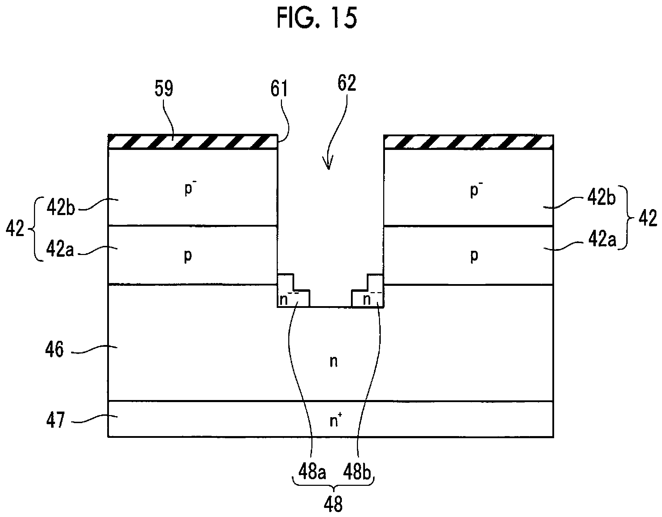

A manufacturing method of the MOSFET of Example 3 will be described. In the MOSFET of Example 3, as shown in FIG. 15, the electric field relaxation layer 48 shown in FIG. 10 is made remain such that the bottom surface (that is, the front surface of the first drift layer 46) of the recess portion 62 is exposed by etching. That is, an etching time is adjusted such that the electric field relaxation layer 48 is made remain in corner portions of the bottom surface and the side surfaces of the recess portion 62, and the electric field relaxation layer 48 is removed at the center of the bottom surface of the recess portion 62. A shape (first portion 48a and second portion 48b) of the electric field relaxation layer 48 shown in FIG. 15 can be obtained by removing solely the mask 59b from the shape shown in FIG. 11 of Example 2 and performing etching in a step of etching the electric field relaxation layer 48. Thereafter, the same steps as those in Example 2 are carried out, whereby it is possible to manufacture the MOSFET.

Even in the above-described manufacturing method, since the electric field relaxation layer 48 can be disposed at the position in contact with the lower end portion 43b of each body layer 42 on the recess portion 62 side, it is possible to suppress concentration of an electric field on the lower end portion 43b. In the above-described manufacturing method, the electric field relaxation layer 48 is etched, whereby the bottom surface of the recess portion 62 is exposed. For this reason, the second drift layer 49 is made to grow inside the recess portion 62, whereby the second drift layer 49 is connected to the first drift layer 46 between the first portion 48a and the second portion 48b. Since the first drift layer 46 and the second drift layer 49 have an n-type impurity concentration higher than that of the electric field relaxation layer 48, when the MOSFET is turned on, a current flows in the connection portion of the first drift layer 46 and the second drift layer 49, whereby it is possible to further reduce on-resistance.

In the above-described examples, although the MOSFET has been described, the technique of the present disclosure may be applied to an insulated gate bipolar transistor (IGBT). A p-type layer is provided instead of the n-type drain contact layer 47, whereby it is possible to obtain the structure of the IGBT.

In the above-described examples, the electric field relaxation layer 48 extends below the lower end portion 43b of the body layer 42. However, a lower end of the electric field relaxation layer 48 may have a depth substantially equal to the lower end portion 43b of each body layer 42. Even in the configuration described above, it is possible to suitably relax an electric field surrounding the lower end portion 43b of each body layer 42.

### Correspondence Relationship

The p-type is an example of a "first conduction type". The n-type is an example of a "second conduction type". The body layer 42 is an example of a "first body layer" and a "second body layer". The source layer 40 is an example of a "first source layer" and a "second source layer". The lower end portion 43b is an example of a "first lower end portion" and a "second lower end portion". The drain contact layer 47 is an example of a "nitride semiconductor substrate".

Although specific examples of the present disclosure have been described above in detail, these are merely for illustration and are not intended to limit the claims. The technique described in the claims also encompasses various modifications and alterations of the specific examples illustrated above. Technical features described in the specification or the drawings may technically be useful alone or in various combinations, and are not limited to the combinations as originally claimed. The technique illustrated in the specification or the drawings may concurrently achieve a plurality of objects, and technical significance thereof resides in achieving one of the objects.

## Claims

1. A nitride semiconductor apparatus comprising:
a nitride semiconductor layer (12);
a gate insulating film (28);
a source electrode (20);
a drain electrode (30); and
a gate electrode (26), wherein:
the nitride semiconductor layer (12) includes
a first body layer exposed to a front surface of the nitride semiconductor layer (12), the first body layer being a first conduction type,
a second body layer exposed to the front surface, the second body layer being the first conduction type,
a drift layer (44) extending from an interval portion (50) to a position in contact with a bottom surface of the first body layer and a position in contact with a bottom surface of the second body layer, and exposed to the front surface in the interval portion (50), the interval portion (50) being a region between the first body layer and the second body layer, the drift layer being a second conduction type,
a first source layer separated from the drift layer (44) by the first body layer and exposed to the front surface, the first source layer being the second conduction type, and
a second source layer separated from the drift layer (44) by the second body layer and exposed to the front surface, the second source layer being the second conduction type;
the gate insulating film (28) covers the front surface over a range in which the first source layer, the first body layer, the drift layer (44), the second body layer, and the second source layer are exposed;
the source electrode (20) is in contact with the first source layer, the first body layer, the second source layer, and the second body layer within a range in which the gate insulating film (28) is not provided;
the drain electrode (30) is in contact with a rear surface of the nitride semiconductor layer (12);
the gate electrode (26) faces the first body layer and the second body layer through the gate insulating film (28); and
the drift layer (44) includes
a first drift layer (46) extending from the position in contact with the bottom surface of the first body layer to the position in contact with the bottom surface of the second body layer, and
an electric field relaxation layer (48) being in contact with a first lower end portion and a second lower end portion, being in contact with the first drift layer (46), and having a second conduction type impurity concentration lower than that of the first drift layer (46), the first lower end portion being a lower end portion of a side surface of the first body layer on the interval portion (50) side, the second lower end portion being a lower end portion of a side surface of the second body layer on the interval portion (50) side.

2. The nitride semiconductor apparatus according to claim 1, wherein:
the electric field relaxation layer (48) extends from the first lower end portion to the second lower end portion; and
the drift layer (44) includes a second drift layer (49) disposed in the interval portion (50) on the front surface side from the electric field relaxation layer (48) and having a second conduction type impurity concentration higher than that of the electric field relaxation layer (48).

3. The nitride semiconductor apparatus according to claim 1, wherein:
the electric field relaxation layer (48) includes
a first portion (48a) being in contact with the first lower end portion, and
a second portion (48b) being in contact with the second lower end portion and separated from the first portion (48a); and
the drift layer (44) includes a second drift layer (49) disposed in the interval portion (50), having a second conduction type impurity concentration higher than that of the electric field relaxation layer (48), and connected to the first drift layer (46) between the first portion (48a) and the second portion (48b).

4. The nitride semiconductor apparatus according to claim 1, wherein the electric field relaxation layer (48) extends to the front surface in the interval portion (50).

5. The nitride semiconductor apparatus according to claim 1, wherein the drift layer (44) includes a drain contact layer (47) disposed on the rear surface side from the first drift layer (46), exposed to the rear surface, and having a second conduction type impurity concentration higher than that of the first drift layer (46).

6. A method of manufacturing a nitride semiconductor apparatus, the method comprising:
making a first drift layer (46) made of a second conduction type nitride semiconductor grow on a front surface of a nitride semiconductor substrate made of a second conduction type nitride semiconductor;
making a body layer made of a first conduction type nitride semiconductor grow on a front surface of the first drift layer (46);
forming a recess portion (62) that passes through the body layer from a front surface of the body layer and reaches the first drift layer (46);
making an electric field relaxation layer (48) made of a second conduction type nitride semiconductor having a second conduction type impurity concentration lower than that of the first drift layer (46) grow inside the recess portion (62) and on the front surface of the body layer;
grinding the electric field relaxation layer (48) to expose the front surface of the body layer and to make the electric field relaxation layer (48) remain inside the recess portion (62);
forming, on both sides of the recess portion (62), a second conduction type source layer that is separated from the first drift layer (46) and the electric field relaxation layer (48) by the body layer and is exposed to the front surface of the body layer;
forming a gate insulating film (28) that covers a range over a front surface of each source layer, the front surface of the body layer, and a front surface of the electric field relaxation layer (48);
forming a gate electrode (26) that faces the body layer through the gate insulating film (28);
forming a source electrode (20) on the front surface of each source layer and the front surface of the body layer within a range in which the gate insulating film (28) is not provided; and
forming a drain electrode (30) on a rear surface of the nitride semiconductor substrate.

7. A method of manufacturing a nitride semiconductor apparatus, the method comprising:
making a first drift layer (46) made of a second conduction type nitride semiconductor grow on a front surface of a nitride semiconductor substrate made of a second conduction type nitride semiconductor;
making a body layer made of a first conduction type nitride semiconductor grow on a front surface of the first drift layer (46);
forming a recess portion (62) that passes through the body layer from a front surface of the body layer and reaches the first drift layer (46);
making an electric field relaxation layer (48) made of a second conduction type nitride semiconductor having a second conduction type impurity concentration lower than that of the first drift layer (46) grow inside the recess portion (62) and on the front surface of the body layer;
removing the electric field relaxation layer (48) on the body layer to expose the front surface of the body layer and to make the electric field relaxation layer (48) remain at a position in contact with at least a lower end portion of each side surface of the body layer on the recess portion (62) side;
after the electric field relaxation layer (48) is etched, making a second drift layer (49) made of a second conduction type nitride semiconductor having a second conduction type impurity concentration higher than that of the electric field relaxation layer (48) grow inside the recess portion (62);
forming, on both sides of the recess portion (62), a second conduction type source layer that is separated from the first drift layer (46), the electric field relaxation layer (48), and the second drift layer (49) by the body layer and is exposed to the front surface of the body layer;
forming a gate insulating film (28) that covers a range over a front surface of each source layer, the front surface of the body layer, and a front surface of the second drift layer (49);
forming a gate electrode (26) that faces the body layer through the gate insulating film (28);
forming a source electrode (20) on the front surface of each source layer and the front surface of the body layer within a range in which the gate insulating film (28) is not provided; and
forming a drain electrode (30) on a rear surface of the nitride semiconductor substrate.
